(19) Europäisches Patentamt / European Patent Office / Office européen des brevets

(11) **EP 3 832 553 B1**

(12) **EUROPEAN PATENT SPECIFICATION**

(45) Date of publication and mention
of the grant of the patent:
**30.04.2025 Bulletin 2025/18**

(21) Application number: **20797361.1**

(22) Date of filing: **13.03.2020**

(51) International Patent Classification (IPC):
**G01R 19/00** *(2006.01)*   **G01R 19/25** *(2006.01)*
**G01R 31/3835** *(2019.01)*   **G06N 3/084** *(2023.01)*
**H02S 50/10** *(2014.01)*

(52) Cooperative Patent Classification (CPC):
**G01R 19/0053; G01R 19/2509; G01R 31/3835;**
**G06N 3/084; H02S 50/10;** Y02E 10/50

(86) International application number:
**PCT/CN2020/079102**

(87) International publication number:
**WO 2021/068454 (15.04.2021 Gazette 2021/15)**

(54) **METHOD FOR IDENTIFYING A MICRO-ENERGY DEVICE ON BASIS OF BP NEURAL NETWORK**

VERFAHREN ZUR BESTIMMUNG EINER MIKROENERGIEVORRICHTUNG AUF BASIS EINES
NEURONALEN BP-NETZWERKS

PROCÉDÉ D'IDENTIFICATION D'UN DISPOSITIF À MICRO-ÉNERGIE SUR LA BASE D'UN
RÉSEAU NEURONAL BP

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **12.10.2019 CN 201910967418**

(43) Date of publication of application:
**09.06.2021 Bulletin 2021/23**

(73) Proprietor: **United Microelectronics Center Co.,
Ltd.
Chongqing 401332 (CN)**

(72) Inventors:
• **ZHANG, Chuting**
**Chongqing 401332 (CN)**
• **WANG, Haopeng**
**Chongqing 401332 (CN)**
• **ZHANG, Bin**
**Chongqing 401332 (CN)**
• **ZENG, Huaiwang**
**Chongqing 401332 (CN)**
• **JIAO, Wenlong**
**Chongqing 401332 (CN)**

• **WANG, Miao**
**Chongqing 401332 (CN)**

(74) Representative: **Canzler & Bergmeier
Patentanwälte
Partnerschaft mbB
Despag-Straße 6
85055 Ingolstadt (DE)**

(56) References cited:
CN-A- 102 567 783    CN-A- 104 535 934
CN-A- 105 067 101    CN-A- 106 569 136
CN-A- 107 576 918    CN-A- 108 445 406
CN-A- 109 444 757    CN-A- 109 444 757
CN-A- 110 728 360    KR-B1- 101 965 832

• SYAFARUDDIN ET AL: "Controlling of artificial
neural network for fault diagnosis of
photovoltaic array", INTELLIGENT SYSTEM
APPLICATION TO POWER SYSTEMS (ISAP),
2011 16TH INTERNATIONAL CONFERENCE ON,
IEEE, 25 September 2011 (2011-09-25), pages 1 -
6, XP032011065, ISBN: 978-1-4577-0807-7, DOI:
10.1109/ISAP.2011.6082219

EP 3 832 553 B1

## Description

### Technical Field

The present disclosure relates to the field of smart micro-energy system, in particular, to an energy identification method for a micro-energy device based on BP neural network.

### Background

At present, smart micro-energy systems with self-sensing, self-awakening, self-learning, and self-adapting gradually replace traditional energy management systems. The accurate identification of input energy is the key to smart micro-energy systems.

CN 109444757 A discloses a method for estimating the remaining power of an electric vehicle power battery.

Since the voltage signal of the micro-energy device is interfered by the material itself and external factors such as the process technology, there may be a variety of noises with different strengths or different frequencies in the voltage signal. How to improve the adaptability of noise and the denoising effect is one of the urgent problems to be solved in the energy recognition of micro-energy devices.

At present, the research directions of machine learning mainly include decision tree, random forest, artificial neural network, Bayesian learning, and so on. Compared with traditional machine learning algorithms such as the K-nearest neighbor algorithm and Bayesian classifier algorithm, back propagation (BP) neural network has obvious advantages in the following aspects:

1) BP neural network has stronger self-learning and self-adapting ability. BP neural network can automatically extract the output data during its training, and adaptively memorize the learned content in the network weights.

2) BP neural network has better generalization ability than traditional machine learning algorithms. Generalization ability usually refers to the ability of a machine or neural network to predict unknown data after a quantity of data training.. Take the smart micro-energy system as an example. When a common machine learning algorithm, such as Naive Bayes classifier, is used to classify the output electrical forms of a variety of micro-energy devices, such algorithm can only classify the current training set samples (i.e., dynamic voltages of the micro-energy devices in an open-circuit state) and extract features, but the feature extraction effect for other data samples is poor. In contrast, the supervised BP neural network model divides the entire model training process into two processes: signal forward propagation and error back propagation. First, the training data enters the model for forward propagation. If there is an error between the result obtained by the output layer and the expected output result, then in the second step, the error is back-propagated and the weight of the hidden layer is updated until the error is minimized. In this way, the weight of the model learned by iterative training reaches the optimal value. At this time, the model has good generalization ability, and is able to classify and identify other data samples more accurately.

3) BP neural network has good fault-tolerant ability, that is, when some neurons of BP neural network are damaged, the accuracy of feature classification and recognition of the whole model is not greatly affected.

4) BP neural network has good nonlinear mapping ability. The essence of BP neural network is to realize a mapping from input to output. The mathematical theory proves that when the number of hidden layer neurons in the three-layer BP neural network structure is sufficient, the neural network can approximate any nonlinear continuous function with any precision.

### Summary

The present disclosure provides a voltage signal identification method for a micro-energy device based on back propagation (BP) neural network. By using a supervised BP neural network model to identify and classify the output electrical forms of micro-energy devices, the accuracy of rapid energy recognition of composite micro-energy devices is improved. To solve the above technical problems, the present disclosure specifically adopts a method as defined in claim 1.

Preferably, the step S1 includes:

S101, continuously sampling a dynamic voltage of an integrated micro-energy device in an open-circuit state to obtain an original voltage signal;
S102, denoising the original voltage signal by an adaptive threshold wavelet transform algorithm; the formula is as follows:

$$\varphi_{2^{-j},k\bullet 2^{-j}}(t)=2^{\frac{j}{2}}\varphi\left(2^{j}t-k\right), \quad WT_{x}(j,k)=2^{\frac{j}{2}}\int_{-\infty}^{+\infty}x(t)\varphi^{*}(2^{j}t-k)dt$$

$2^{-j}$ is a scale factor, $k \bullet 2^{-j}$ is a shift factor, and $\varphi^{*}(t)$ is a conjugate of $\varphi(t)$;

S103, performing a wavelet multi-level decomposition by using the number of wavelet decomposition levels and the wavelet basis function, and obtaining a wavelet decomposition coefficient $w_{j,k}$ of a corresponding level, performing threshold processing on the wavelet decomposition coefficient $w_{j,k}$:

$$w_{j,k}=\begin{cases} w_{j,k} & |w_{j,k}|\geq \gamma \\ 0 & |w_{j,k}|\leq \gamma \end{cases}$$

$\gamma$ is the threshold value and $w_{j,k}$ is the wavelet decomposition coefficient.

Preferably, the step S2 includes: dividing the time window of each segment of the dynamic voltage, and searching a maximum value point in the window, so as to find the position of the to-be-collected R wave peak and obtain the total data set.

Preferably, the step S3 includes:

S301, initializing the structure of the BP neural network;

S302, normalizing the dynamic voltage, noise characteristics and sample sampling rate of the integrated micro-energy device in the open-circuit state as the input of the model, and the characteristic center of the integrated micro-energy device serves as the output of the model;

S303, setting an error function;

S304, dividing the total data set into a training set and a validation set, inputting the training set into the BP neural network model in two parts, and obtaining updated network weights and updated network thresholds after the first input;

S305, after the second input, stopping the training when the training error is 1%; determining the final network weights and the final network thresholds, and obtaining a qualified energy recognition model for micro-energy devices based on BP neural network;

S306, if the training error described in S305 cannot be reached, a new data sample is added to increase data samples for the first input training to update the network weights and the network thresholds, then performing step S305.

Preferably, initializing the structure of the BP neural network in step S301 includes: selecting a node number of an input layer, a node number of a hidden layer, and a node number of an output layer; randomly selecting a weight coefficient of the hidden layer and a weight coefficient of the output layer in the range of [-1, 1]; determining a learning rate and a smoothing factor, and selecting an activation function of the model.

Preferably, the training error includes a difference between the average value of the network weights updated by the first input and the average value of the final network weights, and a difference between the average value of the network thresholds updated by the second input and the average value of the final network thresholds.

Preferably, step S3 further includes: storing the qualified models in a model pool, and counting the qualified models. When the number of models reaches X, testing the obtained X qualified models using a test set and recording the accuracy of the models, so as to obtain the parameters corresponding to the best model.

The integrated micro-energy device includes a micro fuel cell, a vibration energy collector, and a micro photovoltaic cell.

Compared with the traditional technology, the present disclosure has the following beneficial effects:
according to the method of the present disclosure, accurate and rapid energy identification and classification can be carried out, and the classification result is reliable, which has certain directive significance for the energy classification and identification of composite micro-energy devices. The method of the present disclosure has high anti-interference capability. A plurality of characteristics with high influence proportions in energy signal comparison of the micro-energy device are selected, including the dynamic voltage, noise characteristics and sample sampling rate of the micro-energy device in the open-circuit state. The BP neural network is used to identify and classify the energy of composite micro-energy devices. The BP neural network model has good fault-tolerant ability and non-linear mapping ability, so that the deviation of individual characteristic quantity will not greatly influence the overall classification results, so that the classification and recognition results have higher reliability and accuracy.

## Brief Description of the Drawings

FIG. 1 is a schematic flowchart of the present disclosure.
FIG. 2 is a schematic flowchart of the BP neural network analysis process in the present disclosure.

## Detailed Description of the Preferred Embodiments

The specific content of the present disclosure will be described in detail below with reference to the drawings and embodiments.

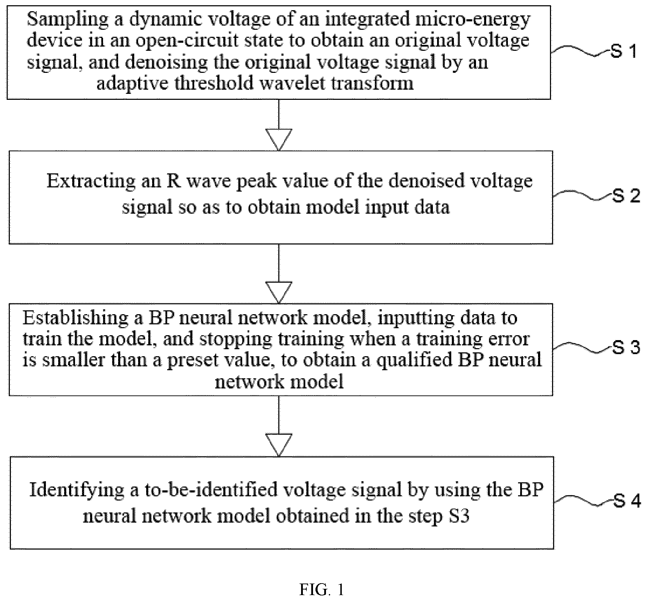

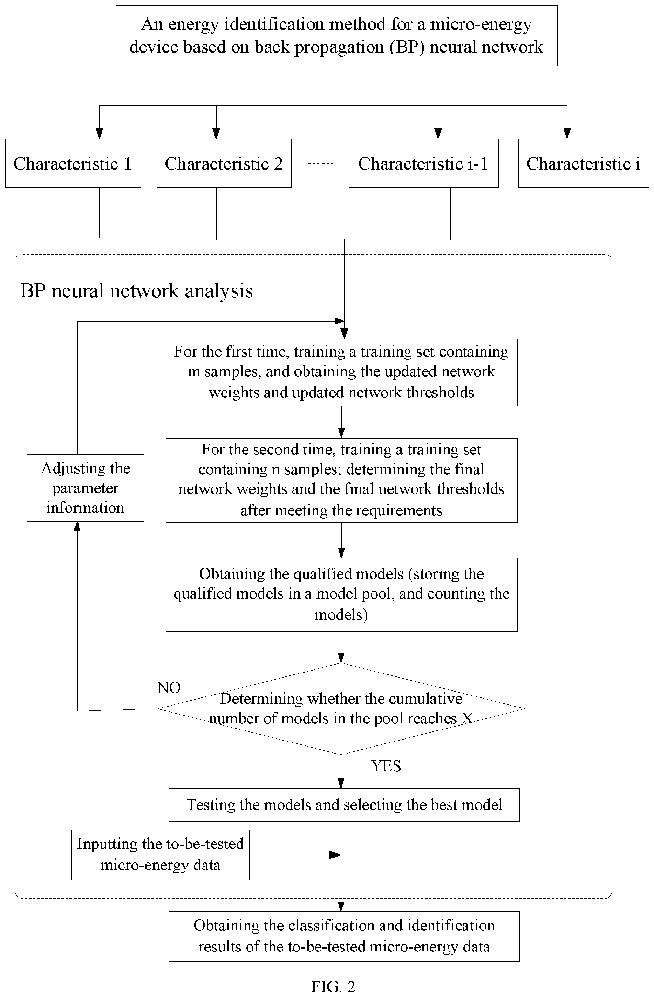

As shown in FIGs. 1 and 2, the present disclosure provides an energy identification method for a micro-energy device based on back propagation (BP) neural network. In this embodiment, the original voltage signal is obtained by continuously sampling the dynamic voltage of three types of micro-energy devices (micro fuel cell, vibration energy collector, and micro photovoltaic cell) in the open-circuit state. The sampled voltage signal containing noise and complex redundant information is subjected to wavelet transforming to remove the noise interference of the original data, thereby completing the preprocessing of the voltage data signal.

Since the voltage signal of the micro-energy device is interfered by the material itself and external factors, there may be a variety of noises with different strengths or different frequencies in the voltage signal. To improve the noise adaptability and denoising effect, an adaptive threshold wavelet transform algorithm is used to denoise the original voltage signal.

The formula of the adaptive threshold wavelet transform algorithm is as follows:

Discrete wavelet function:

$$\varphi_{2^{-j},k \bullet 2^{-j}}(t) = 2^{\frac{j}{2}}\varphi\left(2^{j}t - k\right)$$

$$WT_{x}(j,k) = 2^{\frac{j}{2}}\int_{-\infty}^{+\infty}x(t)\varphi^{*}(2^{j}t - k)dt$$

Discrete wavelet transform:

$2^{-j}$ is the scale factor, $k \bullet 2^{-j}$ is the shift factor, and $\varphi^{*}(t)$ is the conjugate of $\varphi(t)$. Selecting a proper wavelet decomposition level number and a proper wavelet basis function, performing a wavelet multi-level decomposition to obtain a wavelet decomposition coefficient $w_{j,k}$ of a corresponding level. Performing threshold processing on the wavelet decomposition coefficient $w_{j,k}$:

$$w_{j,k} = \begin{cases} w_{j,k} & |w_{j,k}| \geq \gamma \\ 0 & |w_{j,k}| \leq \gamma \end{cases}$$

$\gamma$ is the threshold value and $w_{j,k}$ is the wavelet decomposition coefficient.

The wavelet threshold denoising process can reduce the low-scale and high-frequency interference signals in the original voltage signal data to a certain extent. Then, by extracting the R wave peak value of the denoised voltage signal, the discrete voltage data are obtained. Since the energy of the voltage signal is mostly concentrated on the R wave peak, the R wave peak is regarded as the energy peak of the voltage. By dividing the time window of each segment of the dynamic voltage and searching a maximum value point in the window, the position of the to-be-collected R wave peak can be found.

Let the sample number in the total data set be K, randomly select M samples from the total data set to form a training set as the input of the BP neural network. The number of R wave peak values contained in each sample is N, and M*N wave peak values are contained in M samples. The sampling rate of the training samples calculated according to time T is about $\dfrac{M \bullet N}{T}$, and the sample number in the test set is K-M.

A BP neural network model is established. The model of the present disclosure adopts a three-layer network structure including an input layer, a hidden layer, and an output layer. In the entire training process, first, training set sample data are input into the BP neural network for training, so as to obtain a neural network prediction model. The main steps to establish the BP neural network model are:

S301, initializing the structure of the BP neural network; the node number of the input layer is i, the node number of the hidden layer is j, and the node number of the output is n; randomly selecting a weight coefficient v[i][j] of the hidden layer and a weight coefficient w[j][n] of the output layer in the range of [-1,1]; determining the learning rate a and smoothing factor b, and selecting the sigmoid function as the activation function of the model.

S302, normalizing the dynamic voltage, noise characteristics and sample sampling rate of each micro-energy device in the open-circuit state as the input of the model; the output of the model is the characteristic center of each of the three micro-energy devices.

S303, assigning a random number within the interval [-1, 1] to each connection weight, and the error function is set as:

$$e = \left( \sum_{i=0}^{l} \left( d_{oi} - yo_{oi} \right) \right)^2 / 2$$

$d_{oi}$ is the expected output vector of the corresponding data, $yo_{oi}$ is the output vector of the output layer of the corresponding data.

The specific training steps are shown in FIG. 2. In the present disclosure, the training set is divided into two inputs. m training samples are input at the first time, n training samples are input at the second time, m +n= M. M is the total number of training samples. (m=n=M/2 is selected for the first time, and will be adjusted according to actual data)

S304, for the first time, inputting a training set containing m samples into the BP neural network classification prediction model, and obtaining the updated network weights and updated network thresholds.

S305, for the second time, inputting a training set containing n samples into the BP neural network classification prediction model, stopping the training when the training error is 1%; determining the final network weights and the final network thresholds, and obtaining a suitable energy recognition model for micro-energy devices.

The training error includes the difference between the average value of the network weights updated by the first input and the average value of the final network weights, and the difference between the average value of the network thresholds updated by the second input and the average value of the final network thresholds.

S306, if the training error cannot be reached during the training, adding a new data sample to increase data samples for the first input training to update the network weights and the network thresholds, then performing step S305.

To obtain the best model, the identification method of the present disclosure may also include storing the qualified models in a model pool, and counting the qualified models. When the number of models reaches X, a test set is used to test the obtained X qualified models and record the accuracy of the models, so as to obtain the parameters corresponding to the best model.

When using the BP neural network classification prediction model described in the present disclosure to identify the micro-energy, the results of classification and identification can be obtained simply by inputting the to-be-tested micro-energy data into the model.

Finally, it should be noted that the above embodiments are only used to illustrate the technical schemes of the present disclosure without limitation.

**Claims**

1.  A voltage signal identification method for a micro-energy device

    based on back propagation, BP, neural network, comprising:
    S1, sampling dynamic voltages of integrated micro-energy devices of three types, including a micro fuel cell, a vibration energy collector, and a micro photovoltaic cell, in an open-circuit state to obtain original voltage signals, and denoising the original voltage signals by an adaptive threshold wavelet transform;
    S2, extracting respective peak values R of the denoised original voltage signals, so as to obtain model input data;
    S3, establishing and training a BP neural network model by inputting the model input data into the BP neural network, and stopping training when a training error is smaller than a preset value, to obtain a qualified BP neural network model;
    S4, identifying a to-be-identified voltage signal corresponding to one of the three types of the integrated micro-energy devices by using the qualified BP neural network model obtained in step S3.

2.  The voltage signal identification method for a micro-energy device based on BP neural network according to claim 1, wherein step S1 comprises:

S101, continuously sampling a dynamic voltage of the integrated micro-energy device in the open-circuit state to obtain the original voltage signal;

S102, denoising the original voltage signal by an adaptive threshold wavelet transform algorithm; the formula is as follows:

$$\varphi_{2^{-j},k\bullet2^{-j}}(t) = 2^{\frac{j}{2}}\varphi(2^{j}t-k), \quad WT_x(j,k) = 2^{\frac{j}{2}}\int_{-\infty}^{+\infty}x(t)\varphi^*(2^{j}t-k)dt \ ,$$

wherein $2^{-j}$ is a scale factor, $k\bullet2^{-j}$ is a shift factor, and $\varphi^*(t)$ is a conjugate of $\varphi(t)$;

S103, performing a wavelet multi-level decomposition by using a wavelet decomposition level number and a wavelet basis function,

obtaining a wavelet decomposition coefficient $w_{j,k}$ of a corresponding level, and performing threshold processing on the wavelet decomposition coefficient $w_{j,k}$:

$$w_{j,k} = \begin{cases} w_{j,k} & |w_{j,k}| \ge \gamma \\ 0 & |w_{j,k}| \le \gamma \end{cases}$$

wherein $\gamma$ is a threshold value, and $w_{j,k}$ is a wavelet decomposition coefficient.

3. The voltage signal identification method for a micro-energy device based on BP neural network according to claim 2, wherein step S2 comprises: dividing a time window of each segment of the dynamic voltage, and searching a maximum value point in the window, to find a position of a to-be-collected peak value R and obtain a total data set.

4. The voltage signal identification method for a micro-energy device based on BP neural network according to claim 3, wherein step S3 comprises:

S301, initializing a structure of the BP neural network;

S302, normalizing the dynamic voltage, noise characteristics and sample sampling rate of the integrated micro-energy device in the open-circuit state as an input of the model, and a characteristic center of each integrated micro-energy device serves as an output of the model;

S303, setting an error function;

S304, dividing the total data set into a training set and a validation set, inputting the training set into the BP neural network model in two parts, and obtaining updated network weights and updated network thresholds after a first input;

S305, after a second input, stopping the training when the training error is 1%; determining the final network weights and the final network thresholds, and obtaining a qualified energy recognition model for micro-energy devices based on BP neural network;

S306, if the training error in step S305 cannot be reached, a new data sample is added to increase data samples for the first input training to update the network weights and the network thresholds, then performing step S305.

5. The voltage signal identification method for a micro-energy device based on BP neural network according to claim 4, wherein initializing the structure of the BP neural network in step S301 comprises:
selecting a node number of an input layer, a node number of a hidden layer, and a node number of an output layer;
randomly selecting a weight coefficient of the hidden layer and a weight coefficient of the output layer in a range of [-1, 1]; determining a learning rate and a smoothing factor, and selecting an activation function of the model.

6. The voltage signal identification method for a micro-energy device based on BP neural network according to claim 4, wherein the training error includes a difference between an average value of the network weights updated by the first input and an average value of the final network weights, and a difference between an average value of the network thresholds updated by the second input and an average value of the final network thresholds.

7. The voltage signal identification method for a micro-energy device based on BP neural network according to claim 4, wherein step S3 further comprises: storing the qualified models in a model pool, and counting the qualified models; when the number of models reaches X, testing the obtained X qualified models using a test set and recording accuracy of the models, so as to obtain parameters corresponding to the best model.

**Patentansprüche**

1. Verfahren zur Identifizierung von Spannungssignalen für eine Mikroenergievorrichtung, die auf einem neuronalen Netzwerk mit Rückwärtspropagation, BP, basiert, umfassend:

   S1, Abtasten dynamischer Spannungen von integrierten Mikroenergievorrichtungen von drei Typen, einschließlich einer Mikrobrennstoffzelle, eines Vibrationsenergiekollektors und einer Mikrophotovoltaikzelle, in einem Leerlaufzustand, um ursprüngliche Spannungssignale zu erhalten, und Entrauschen der ursprünglichen Spannungssignale durch eine adaptive Schwellwert-Wavelet-Transformation;

   S2, Extrahieren jeweiliger Spitzenwerte R der entrauschten ursprünglichen Spannungssignale, um Modelleingabedaten zu erhalten;

   S3, Erstellen und Trainieren eines neuronalen BP-Netzwerkmodells durch Eingeben der Modelleingabedaten in das neuronale BP-Netzwerk und Stoppen des Trainierens, wenn ein Trainingsfehler kleiner als ein voreingestellter Wert ist, um ein qualifiziertes neuronales BP-Netzwerkmodell zu erhalten;

   S4, Identifizieren eines zu identifizierenden Spannungssignals, das einem der drei Typen der integrierten Mikroenergievorrichtungen entspricht, durch Verwenden des in Schritt S3 erhaltenen qualifizierten neuronalen BP-Netzwerkmodells.

2. Verfahren zur Identifizierung von Spannungssignalen für eine Mikroenergievorrichtung, die auf einem neuronalen BP-Netzwerk basiert, nach Anspruch 1, wobei Schritt S1 umfasst:

   S101, kontinuierliches Abtasten einer dynamischen Spannung der integrierten Mikroenergievorrichtung im Leerlaufzustand, um das ursprüngliche Spannungssignal zu erhalten;

   S102, Entrauschen des ursprünglichen Spannungssignals durch einen adaptiven Schwellwert-Wavelet-Transformationsalgorithmus; wobei die Formel wie folgt lautet:

$$\varphi_{2^{-j},k\cdot 2^{-j}}(t) = 2^{\frac{j}{2}}\varphi(2^{j}t - k), \ WT_x(j,k) = 2^{\frac{j}{2}}\int_{-\infty}^{+\infty}x(t)\varphi^{*}(2^{j}t - k)dt,$$

   wobei $2^{-i}$ ein Skalierungsfaktor ist, $k \cdot 2^{-j}$ ein Verschiebungsfaktor ist und $\varphi^{*}(t)$ eine Konjugierte von $\varphi(t)$ ist, S103, Durchführen einer Wavelet-Mehrpegelzerlegung durch Verwenden einer Wavelet-Zerlegungspegelzahl und einer Wavelet-Basisfunktion, Erhalten eines Wavelet-Zerlegungskoeffizienten $w_{j,k}$ eines entsprechenden Pegels und Durchführen einer Schwellwertverarbeitung an dem Wavelet-Zerlegungskoeffizienten $w_{j,k}$:

$$w_{j,k} = \begin{cases} w_{j,k} & |w_{j,k}| \geq \gamma \\ 0 & |w_{j,k}| \leq \gamma \end{cases}$$

   wobei $\gamma$ ein Schwellwertwert ist und $w_{j,k}$ ein Wavelet-Zerlegungskoeffizient ist.

3. Verfahren zur Identifizierung von Spannungssignalen für eine Mikroenergievorrichtung, die auf einem neuronalen BP-Netzwerk basiert, nach Anspruch 2, wobei Schritt S2 umfasst: Teilen eines Zeitfensters jedes Segments der dynamischen Spannung und Suchen eines Maximalwertpunkts in dem Fenster, um eine Position eines zu sammelnden Spitzenwerts R zu finden und einen Gesamtdatensatz zu erhalten.

4. Verfahren zur Identifizierung von Spannungssignalen für eine Mikroenergievorrichtung, die auf einem neuronalen BP-Netzwerk basiert, nach Anspruch 3, wobei Schritt S3 umfasst:

   S301, Initialisieren einer Struktur des neuronalen BP-Netzwerks;

   S302, Normalisieren der dynamischen Spannung, der Rauscheigenschaften und Abtasten der Abtastrate der integrierten Mikroenergievorrichtung im Leerlaufzustand als eine Eingabe des Modells, und eine charakteristische Mitte jeder integrierten Mikroenergievorrichtung dient als eine Ausgabe des Modells;

   S303, Einstellen einer Fehlerfunktion;

   S304, Teilen des Gesamtdatensatzes in einen Trainingssatz und einen Validierungssatz, Eingeben des Trainingssatzes in das neuronale BP-Netzwerkmodell in zwei Teilen und Erhalten aktualisierter Netzwerkgewichtungen und aktualisierter Netzwerkschwellwerte nach einer ersten Eingabe;

   S305, nach einer zweiten Eingabe, Stoppen des Trainierens, wenn der Trainingsfehler 1 % beträgt; Bestimmen der endgültigen Netzwerkgewichtungen und der endgültigen Netzwerkschwellwerte und Erhalten eines qualifizierten Energieerkennungsmodells für Mikroenergievorrichtungen, die auf einem neuronalen BP-Netzwerk basieren;

S306, wenn der Trainingsfehler in Schritt S305 nicht erreicht werden kann, wird eine neue Datenabtastung hinzugefügt, um Datenabtastungen für das erste Eingabetraining zu erhöhen, um die Netzwerkgewichtungen und die Netzwerkschwellwerte zu aktualisieren, dann Durchführen von Schritt S305.

5. Verfahren zur Identifizierung von Spannungssignalen für eine Mikroenergievorrichtung, die auf einem neuronalen BP-Netzwerk basiert, nach Anspruch 4, wobei das Initialisieren der Struktur des neuronalen BP-Netzwerks in Schritt S301 umfasst: Auswählen einer Knotenzahl einer Eingabeschicht, einer Knotenzahl einer verborgenen Schicht und einer Knotenzahl einer Ausgabeschicht; zufälliges Auswählen eines Gewichtungskoeffizienten der verborgenen Schicht und eines Gewichtungskoeffizienten der Ausgabeschicht in einem Bereich von [-1, 1]; Bestimmen einer Lernrate und eines Glättungsfaktors und Auswählen einer Aktivierungsfunktion des Modells.

6. Verfahren zur Identifizierung von Spannungssignalen für eine Mikroenergievorrichtung, die auf einem neuronalen BP-Netzwerk basiert, nach Anspruch 4, wobei der Trainingsfehler eine Differenz zwischen einem Mittelwert der Netzwerkgewichtungen, die durch die erste Eingabe aktualisiert werden, und einem Mittelwert der endgültigen Netzwerkgewichtungen und eine Differenz zwischen einem Mittelwert der Netzwerkschwellwerte, die durch die zweite Eingabe aktualisiert werden, und einem Mittelwert der endgültigen Netzwerkschwellwerte umfasst.

7. Verfahren zur Identifizierung von Spannungssignalen für eine Mikroenergievorrichtung, die auf einem neuronalen BP-Netzwerk basiert, nach Anspruch 4, wobei Schritt S3 ferner umfasst: Speichern der qualifizierten Modelle in einem Modellpool und Zählen der qualifizierten Modelle; wenn die Anzahl der Modelle X erreicht, Testen der erhaltenen X qualifizierten Modelle unter Verwenden eines Testsatzes und Aufzeichnen der Genauigkeit der Modelle, um Parameter zu erhalten, die dem besten Modell entsprechen.

## Revendications

1. Procédé d'identification de signal de tension pour un dispositif à micro-énergie basé sur un réseau neuronal de rétro-propagation, BP, comprenant :

   S1, échantillonner des tensions dynamiques de dispositifs à micro-énergie intégrés de trois types, comprenant une micro-cellule à combustible, un collecteur d'énergie vibratoire, et une micro-cellule photovoltaïque, dans un état de circuit ouvert pour obtenir des signaux de tension originaux, et débruiter les signaux de tension originaux par une transformée en ondelettes à seuil adaptatif ;
   S2, extraire des valeurs de crête respectives R des signaux de tension originaux débruités, de manière à obtenir des données d'entrée de modèle ;
   S3, établir et former un modèle de réseau neuronal BP en entrant les données d'entrée de modèle dans le réseau neuronal BP, et arrêter la formation lorsqu'une erreur de formation est inférieure à une valeur prédéfinie, pour obtenir un modèle de réseau neuronal BP qualifié ;
   S4, identifier un signal de tension à identifier correspondant à l'un des trois types des dispositifs à micro-énergie intégrés en utilisant le modèle de réseau neuronal BP qualifié obtenu à l'étape S3.

2. Procédé d'identification de signal de tension pour un dispositif à micro-énergie basé sur un réseau neuronal BP selon la revendication 1, dans lequel l'étape S1 comprend :

   S101, échantillonner en continu une tension dynamique du dispositif à micro-énergie intégré dans l'état de circuit ouvert pour obtenir le signal de tension original ;
   S102, débruiter le signal de tension original par un algorithme de transformée en ondelettes à seuil adaptatif ; la formule est la suivante :

$$\varphi_{2^{-j},k\bullet 2^{-j}}(t) = 2^{\frac{j}{2}}\varphi(2^{j}t - k), \ \ WT_x(j,k) = 2^{\frac{j}{2}}\int_{-\infty}^{+\infty}x(t)\varphi^{*}(2^{j}t - k)dt,$$

   dans lequel $2^{-j}$ est un facteur d'échelle, $k \bullet 2^{-j}$ est un facteur de décalage, et $\varphi^{*}(t)$ est un conjugué de $\varphi(t)$ ; S103, effectuer une décomposition multi-niveaux en ondelettes en utilisant un nombre de niveaux de décomposition en ondelettes et une fonction de base d'ondelettes, obtenir un coefficient de décomposition d'ondelettes $w_{j,k}$ d'un niveau correspondant, et effectuer un traitement de seuil sur le coefficient de décomposition d'ondelettes $\mathbf{w_{j,k}}$ :

$$\mathbf{w_{j,k}} = \begin{cases} \mathbf{w_{j,k}} & |\mathbf{w_{j,k}}| \geq \boldsymbol{\gamma} \\ \mathbf{0} & |\mathbf{w_{j,k}}| \leq \boldsymbol{\gamma} \end{cases}$$

dans lequel $\gamma$ est une valeur de seuil, et $\mathbf{w_{j,k}}$ est un coefficient de décomposition d'ondelettes.

3. Procédé d'identification de signal de tension pour un dispositif à micro-énergie basé sur un réseau neuronal BP selon la revendication 2, dans lequel l'étape S2 comprend : diviser une fenêtre temporelle de chaque segment de la tension dynamique, et rechercher un point de valeur maximale dans la fenêtre, pour trouver une position d'une valeur de crête à collecter R et obtenir un ensemble de données total.

4. Procédé d'identification de signal de tension pour un dispositif à micro-énergie basé sur un réseau neuronal BP selon la revendication 3, dans lequel l'étape S3 comprend :

S301, initialiser une structure du réseau neuronal BP ;
S302, normaliser la tension dynamique, les caractéristiques de bruit et échantillonner la fréquence d'échantillonnage du dispositif à micro-énergie intégré dans l'état de circuit ouvert en tant qu'entrée du modèle, et un centre caractéristique de chaque dispositif à micro-énergie intégré sert de sortie du modèle ;
S303, définir une fonction d'erreur ;
S304, diviser l'ensemble de données total en un ensemble de formation et un ensemble de validation, entrer l'ensemble de formation dans le modèle de réseau neuronal BP en deux parties, et obtenir des poids de réseau mis à jour et des seuils de réseau mis à jour après une première entrée ;
S305, après une seconde entrée, arrêter la formation lorsque l'erreur de formation est de 1 % ; déterminer les poids de réseau finaux et les seuils de réseau finaux, et obtenir un modèle de reconnaissance d'énergie qualifié pour des dispositifs à micro-énergie basés sur un réseau neuronal BP ;
S306, si l'erreur de formation à l'étape S305 ne peut pas être atteinte, un nouvel échantillon de données est ajouté pour augmenter les échantillons de données pour la formation de première entrée pour mettre à jour les poids de réseau et les seuils de réseau, puis effectuer l'étape S305.

5. Procédé d'identification de signal de tension pour un dispositif à micro-énergie basé sur un réseau neuronal BP selon la revendication 4, dans lequel l'initialisation de la structure du réseau neuronal BP à l'étape S301 comprend : sélectionner un nombre de nœuds d'une couche d'entrée, un nombre de nœuds d'une couche cachée, et un nombre de nœuds d'une couche de sortie ; sélectionner aléatoirement un coefficient de pondération de la couche cachée et un coefficient de pondération de la couche de sortie dans une plage de [-1, 1] ; déterminer une fréquence d'apprentissage et un facteur de lissage, et sélectionner une fonction d'activation du modèle.

6. Procédé d'identification de signal de tension pour un dispositif à micro-énergie basé sur un réseau neuronal BP selon la revendication 4, dans lequel l'erreur de formation comprend une différence entre une valeur moyenne des poids de réseau mis à jour par la première entrée et une valeur moyenne des poids de réseau finaux, et une différence entre une valeur moyenne des seuils de réseau mis à jour par la seconde entrée et une valeur moyenne des seuils de réseau finaux.

7. Procédé d'identification de signal de tension pour un dispositif à micro-énergie basé sur un réseau neuronal BP selon la revendication 4, dans lequel l'étape S3 comprend en outre : stocker les modèles qualifiés dans un groupe de modèles, et compter les modèles qualifiés ; lorsque le nombre de modèles atteint X, tester les X modèles qualifiés obtenus en utilisant un ensemble de test et enregistrer la précision des modèles, de manière à obtenir des paramètres correspondant au meilleur modèle.

| | |
|---|---|
| Sampling a dynamic voltage of an integrated micro-energy device in an open-circuit state to obtain an original voltage signal, and denoising the original voltage signal by an adaptive threshold wavelet transform | S 1 |

| | |
|---|---|
| Extracting an R wave peak value of the denoised voltage signal so as to obtain model input data | S 2 |

| | |
|---|---|
| Establishing a BP neural network model, inputting data to train the model, and stopping training when a training error is smaller than a preset value, to obtain a qualified BP neural network model | S 3 |

| | |
|---|---|
| Identifying a to-be-identified voltage signal by using the BP neural network model obtained in the step S3 | S 4 |

FIG. 1

An energy identification method for a micro-energy device based on back propagation (BP) neural network

| Characteristic 1 | Characteristic 2 | ······ | Characteristic i-1 | Characteristic i |

BP neural network analysis

For the first time, training a training set containing m samples, and obtaining the updated network weights and updated network thresholds

For the second time, training a training set containing n samples; determining the final network weights and the final network thresholds after meeting the requirements

Adjusting the parameter information

Obtaining the qualified models (storing the qualified models in a model pool, and counting the models)

NO

Determining whether the cumulative number of models in the pool reaches X

YES

Testing the models and selecting the best model

Inputting the to-be-tested micro-energy data

Obtaining the classification and identification results of the to-be-tested micro-energy data

FIG. 2

## EP 3 832 553 B1

**Patent documents cited in the description**

- CN 109444757 A